# EUROPEAN PATENT APPLICATION

(11) **EP 4 773 525 A1**
(43) Date of publication of application: **08.07.2026**
(21) Application number: 25223690.6
(22) Date of filing: 16.12.2025
(51) Int. Cl.: H04B 17/13

(54) **CALIBRATION METHOD FOR PARAMETERS OF A POWER AMPLIFIER**

(30) Priority: 06.01.2025 TW 114100472
(71) Applicant: Arcadyan Technology Corporation, Hsinchu City 30071 (TW)
(72) Inventor: Chang, Wei-Kang, 30071 Hsinchu City (TW); Chen, Che-Min, 30071 Hsinchu City (TW)
(74) Representative: Stevens Hewlett & Perkins

(57) **Abstract**

The present invention is related to a calibration method for parameters of a power amplifier, wherein the power amplifier has N parameters each having a preset range of standard power output value. The method comprises: step 1: manually calibrate parameter values of N1 parameters among the N parameters to obtain calibrated parameter values of the N1 parameters; step 2: input the calibrated parameter values of the N1 parameters into an Al background process program to calculate and derive calculated parameter values of remaining N2 parameters by the Al background process program, wherein N2 = N - N1; and step 3: install the calibrated parameter values of the N parameters in the power amplifier to finish calibration of the parameters of the amplifier.

## Description

### CROSS-REFERENCE TO RELATED APPLICATION

This application claims the priority of Taiwanese patent application No. 114100472, filed on January 6, 2025, which is incorporated herewith by reference.

### BACKGROUND OF THE INVENTION

### 1. Field of the Invention

The present invention relates generally to a network product power amplifier parameter prediction and radio frequency calibration optimization technology, and more particularly, to a calibration method for parameters of a power amplifier for network communication products.

### 2. The Prior Arts

Wireless network communication products on the market mainly include wireless communication components for transmitting and receiving wireless signals, especially radio frequency (RF) communication components for transmitting and receiving radio frequency wireless signals. The transmitter part includes a power amplifier for amplifying the power of the radio frequency wireless signal to be transmitted.

When the RF communication component is manufactured, the power amplifier therein needs to be calibrated to meet product specifications. Currently, the industry mainly uses manual methods to calibrate the parameters of power amplifiers based on trial-and-error approach. However, such manual methods take considerable man-hours, thereby slowing down production speed and affecting productivity.

Therefore, there is a need for an efficient power amplifier parameter calibration method to overcome the above problems, thereby improving production speed and increasing yield.

According to the required specifications of wireless network communication products, each parameter of the power amplifier has a corresponding preset range of standard power output value. The purpose of power amplifier parameter calibration is to adjust the parameter value of each parameter so that the power value of the signal output by the RF communication component with the power amplifier meets the preset range of standard power output value corresponding to the parameter being calibrated.

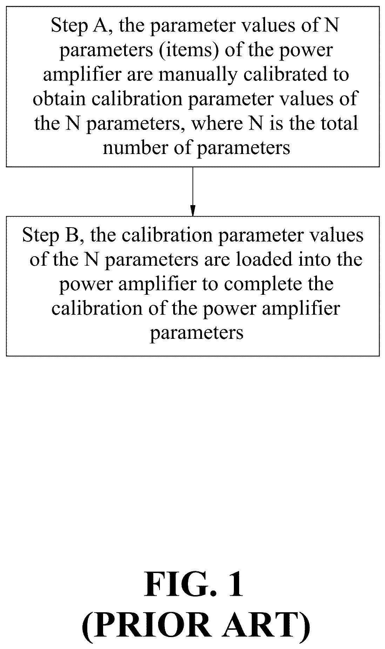

FIG. 1 is a flow chart of a method for manually calibrating power amplifier parameters according to the prior art.

Refer to FIG. 1. First, in step A, the parameter values of N parameters (items) of the power amplifier are manually calibrated to obtain calibration parameter values of the N parameters, where N is the total number of parameters. Next, in step B, the calibration parameter values of the N parameters are loaded into the power amplifier to complete the calibration of the power amplifier parameters.

In the prior art, manual calibration of a power amplifier may be performed using a test computer and an one-box-tester (OBT), which is connected to the test computer. The RF communication component with the power amplifier (as the device under test (DUT)) can be first installed in the one-box-tester, and then the operator (OP) controls the RF communication component to transmit the RF signal through the operating interface of the test computer. The one-box-tester can receive the RF signal transmitted by the RF communication component, measure the power output value of the RF signal, and then send back the information of the power output value to the test computer.

As in the trial-and-error approach, the operator can first calibrate the first parameter of the N parameters of the power amplifier, which has a corresponding first preset range of standard power output value, and manually or automatically select to apply the parameter value of the first parameter through the test computer, and then confirm whether the power output value of the radio frequency signal emitted by the radio frequency communication element falls within the first preset range of standard power output value. If so, the parameter value of the selected and applied first parameter is the calibration parameter value; if not, reselect and apply other parameter values of the first parameter until the calibration parameter value of the first parameter corresponding to the power output value of the first preset range of standard power output value is found.

By repeating the above trial-and-error steps, the calibration of all parameters of the power amplifier can be completed and all calibration parameter values can be obtained. Finally, all calibration parameter values are loaded into the power amplifier to complete the power amplifier parameter calibration. For example, the calibration parameter values may be loaded into the power amplifier via a test computer, or the calibration parameter values may be loaded into the power amplifier via a one-box-tester.

However, the manual calibration of the power amplifier in the aforementioned prior art takes a lot of man-hours, thereby slowing down the production speed and affecting the yield. Therefore, the present invention proposes a calibration method for parameters of a power amplifier to shorten the calibration time of the power amplifier, speed up the production speed and improve the yield.

### SUMMARY OF THE INVENTION

In order to effectively solve the aforementioned problems, according to one aspect of the present invention, a method for calibrating parameters of a power amplifier is proposed, wherein the power amplifier has N parameters, each of the N parameters has a preset range of standard power output value, and the method comprises: step 1, manually calibrating parameter values of N1 parameters among the N parameters to obtain calibration parameter values of the N1 parameters; step 2, inputting the calibration parameter values of the N1 parameters into an artificial intelligence background process program to calculate the calibration parameter values of the remaining N2 parameters by the artificial intelligence background process program, wherein N2 = N - N1; and step 3, loading the calibration parameter values of the N parameters into the power amplifier to complete the calibration of the power amplifier parameters.

According to an embodiment of the present invention, preferably, step 1 includes: step 1-1, manually inputting a parameter value of a first parameter among the N1 parameters into the power amplifier; step 1-2, reading the power output value of the power amplifier; step 1-3, confirming whether the power output value of the power amplifier is within a preset range of standard power output value corresponding to the first parameter, if so, the input parameter value is a calibration parameter value of the first parameter, and continue to calibrate another parameter, if not, repeating steps 1-1 to 1-3; and step 1-4, obtaining the calibration parameter values of the N1 parameters by repeating steps 1-1 to 1-3.

According to an embodiment of the present invention, preferably, step 2 includes: step 2-1, providing a first power amplifier, the first power amplifier having the N parameters, the first power amplifier having been manually calibrated, inputting the calibration parameter values of the N parameters of the first power amplifier and the corresponding power output value into an artificial intelligence server to establish a first parameter prediction model, and loading the first parameter prediction model into the artificial intelligence background process program; and step 2-2, inputting the calibration parameter values of the N1 parameters of the power amplifier into the first parameter prediction model of the artificial intelligence background process program, so as to calculate the calibration parameter values of the remaining N2 parameters of the power amplifier by means of the first parameter prediction model.

According to an embodiment of the present invention, preferably, the method further includes: step 4, inputting the calibration parameter values of the N parameters of the power amplifier and the corresponding power output values into the artificial intelligence server to establish a second parameter prediction model, and loading the second parameter prediction model into the artificial intelligence background process program to update the parameter prediction model of the artificial intelligence background process program.

According to an embodiment of the present invention, preferably, the artificial intelligence background process program is loaded into an artificial intelligence edge computing box, and the artificial intelligence edge computing box is connected to a test computer.

According to an embodiment of the present invention, preferably, the method of establishing a parameter prediction model using the artificial intelligence server includes: a linear regression algorithm, a random forest regression algorithm, a gradient boosting regression algorithm, a support vector regression algorithm, a neural network algorithm, or a combination thereof.

According to an embodiment of the present invention, preferably, step 1-1 includes: using a one-box-tester connected to a test computer; connecting a radio frequency communication component with the power amplifier to the one-box-tester; and manually inputting the parameter value of the first parameter among the N1 parameters into the power amplifier via the test computer and the one-box-tester to control the radio frequency communication component to transmit a radio frequency signal.

According to an embodiment of the present invention, preferably, step 1-2 includes: using the one-box-tester to receive an RF signal and read a power value of the RF signal, wherein the power value is the power output value of the power amplifier corresponding to the parameter value of the first parameter.

According to an embodiment of the present invention, preferably, step 1-3 include: using the one-box-tester to transmit the power value of the RF signal back to the test computer; and using the test computer to confirm whether the power value of the RF signal is within a preset range of standard power output value corresponding to the first parameter.

According to another aspect of the present invention, a radio frequency communication element is provided, comprising: a power amplifier calibrated by the calibration method described above.

The calibration method for parameters of a power amplifier of the present invention can achieve the effect of improving production speed and increasing yield compared with the prior art.

In order to enable those skilled in the art to understand the objective, features and effects of the present invention, the present invention is described in detail by means of the following specific embodiments and the accompanying drawings.

### BRIEF DESCRIPTION OF THE DRAWINGS

The present invention will be apparent to those skilled in the art by reading the following detailed description of a preferred embodiment thereof, with reference to the attached drawings, in which:
FIG. 1 is a flowchart of a method for manually calibrating power amplifier parameters according to the prior art;
FIG. 2 is a flowchart of a calibration method for parameters of a power amplifier according to an embodiment of the present invention;
FIG. 3 is a flowchart of step 1 in the method of FIG. 2; and
FIG. 4 is a flowchart of step 2 in the method of FIG. 2.

### DETAILED DESCRIPTION OF THE PREFERRED EMBODIMENT

The accompanying drawings are included to provide a further understanding of the invention, and are incorporated in and constitute a part of this specification. The drawings illustrate embodiments of the invention and, together with the description, serve to explain the principles of the invention.

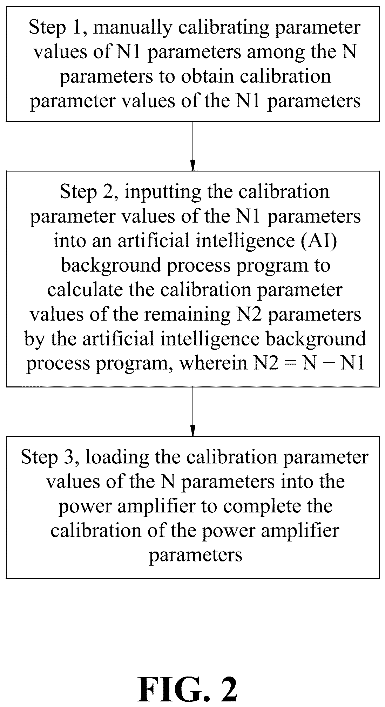

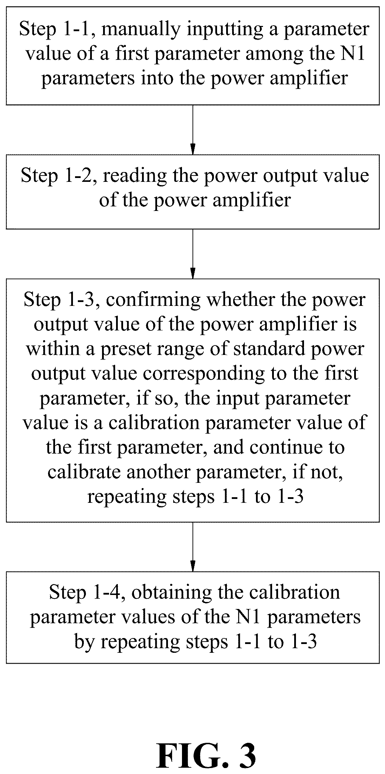

Refer to FIG. 2 and FIG. 3. First, in step 1, as in the method and procedure of the prior art, only the parameter values of N1 parameters out of the N parameters of the power amplifier are manually calibrated, where N is the total number of parameters, and N1<N. According to the embodiment of the present invention, preferably, the following selection of N1 can be used: N1 ≤ N/5, N1 ≤ N/10, N1 ≤ N/15, or N1 ≤ N/20, but the present invention is not limited thereto.

Step 1 of FIG. 2 may further include steps 1-1 to 1-4 as shown in FIG. 3.

Refer to FIG. 3. First, in step 1-1, the parameter values of the first parameter among N1 parameters are manually input into the power amplifier. In step 1-2, the power output value of the power amplifier is read. In step 1-3, it is to determine whether the power output value of the power amplifier is within the preset range of standard power output value corresponding to the first parameter. If so, the input parameter value is the calibration parameter value of the first parameter. If not, steps 1-1 to 1-3 are repeated. Finally, in step 1-4, standard parameter values of N1 parameters are obtained by repeating steps 1-1 to 1-3.

According to an embodiment of the present invention, step 1-1 may include: using a one-box-tester, which can be connected to a test computer by wire or wirelessly; connecting a radio frequency communication component with a power amplifier to the one-box-tester; and manually inputting a parameter value of a first parameter among N1 parameters to the power amplifier via the test computer and the one-box-tester to control the radio frequency communication component to transmit a radio frequency signal.

The one-box-tester used in the present invention can be a general commercially available industry standard product, such as: the IQxel-M^{™} multi-DUT and multi-communication wireless connection test system provided by LITEPOINT, the WT-428 wireless connection tester provided by LinkWen, the E6640A wireless tester provided by Keysight Technologies, etc., but the present invention is not limited thereto.

According to an embodiment of the present invention, step 1-2 may include: using a one-box-tester to receive a radio frequency signal transmitted by a radio frequency communication component and read a power value of the radio frequency signal. At this time, the power value of the radio frequency signal is the power output value of the power amplifier corresponding to the parameter value of the first parameter.

According to an embodiment of the present invention, steps 1-3 may include: using a one-box-tester to send back the power value of the RF signal to a test computer; and using the test computer to determine whether the power value of the RF signal is within a preset range of standard power output value corresponding to the first parameter.

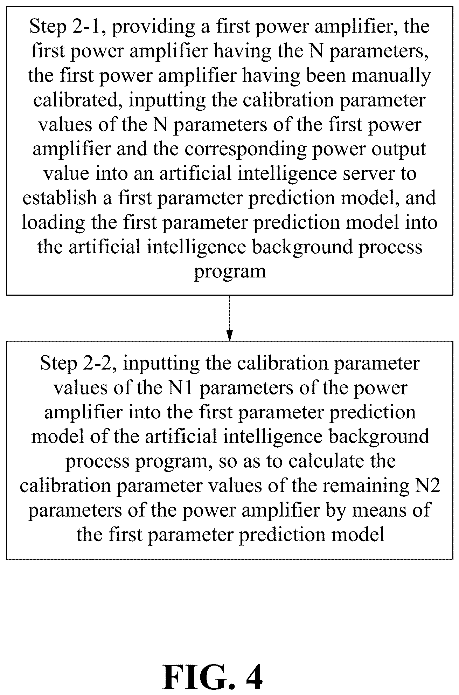

Next, refer to FIGS. 2 and 4. After completing the manual calibration of the N1 parameters of the power amplifier in step 1, the calibration parameter values of the N1 parameters are input into the AI background process program (AI Daemon) to calculate the calibration parameter values of the remaining N2 parameters by the AI background process program, where N2 = N - N1, as shown in step 2.

The AI background process program used in the present invention can be installed in an edge AI computing box that is a commercially available industry standard product, such as: the RISC-based Box computer provided by Advantech Corporation (ADVANTECH), the AIX-600 and AIX-800 advanced interactive execution systems provided by System Electronics Corporation (SYSGRATION), the BOXER-8220AI embedded computer provided by AAEON Corporation (AAEON)...etc., but the present invention is not limited thereto.

Step 2 of FIG. 2 may further include steps 2-1 to 2-2 as shown in FIG. 4.

Refer to FIG. 4. First, in step 2-1, a first power amplifier is provided. The first power amplifier has N parameters and has been manually calibrated. The calibration parameter values of the N parameters of the first power amplifier that have been manually calibrated and the corresponding power output values are input into an AI server to establish a first parameter prediction model, and the first parameter prediction model is loaded into the AI background process program. In the present invention, relevant information data (calibration parameter values and/or corresponding power output values) of the first power amplifier that has been manually calibrated is used to provide a first parameter prediction model trained and established by an AI server, so as to serve as a calculation basis for calculating the calibration parameter values of the remaining N2 parameters to be calibrated based on the calibration parameter values of the N1 parameters of the power amplifier. In step 2-2, the calibration parameter values of N1 parameters of the power amplifier are input into the first parameter prediction model of the AI background process program, so as to calculate the calibration parameter values of the remaining N2 parameters of the power amplifier by the first parameter prediction model. Here, the first parameter prediction model of the AI background process program can not only calculate the calibration parameter values of the remaining N2 parameters, but also calculate the power output values corresponding to the calibration parameter values of the remaining N2 parameters. In the present invention, the AI server can be connected to a computer and an edge AI computing box by wire or wirelessly, wherein the edge AI computing box is installed with an AI background process program.

According to another embodiment of the present invention, in step 2-2, the calibration parameter values of N1 parameters of the power amplifier and the corresponding power output values can be input into the first parameter prediction model of the AI background process program to improve the operation (e.g., prediction) accuracy of the first parameter prediction model of the AI background process program.

According to an embodiment of the present invention, the method for establishing a parameter prediction model by an AI server may include: a linear regression algorithm, a random forest regression algorithm, a gradient boosting regression algorithm, a support vector regression algorithm, a neural network algorithm, or a combination thereof.

Finally, refer to FIG. 2. In step 3, the calibration parameter values of the N parameters are loaded into the power amplifier to complete the calibration of the power amplifier parameters.

For example, Table 1 below shows a comparison between the power output values corresponding to the calibration parameter values of 20 parameter items of a power amplifier calculated using the AI background process program of the present invention and the power output values actually measured by a one-box-tester after the calibration parameter values of the 20 parameter items calculated (predicted) above are loaded into the power amplifier.

**Table 1:**

| Parameter Item | Preset range of standard power output value | Calculated power output value | Actual measured power output value | Error |
|---|---|---|---|---|
| 01 | 18~22 | 18.55 | 18.46 | 0.5% |
| 02 | 18~22 | 18.01 | 18.50 | -2.6% |
| 03 | 18~22 | 19.81 | 18.43 | 7.5% |
| 04 | 18~22 | 18.47 | 18.44 | 0.2% |
| 05 | 15~19 | 16.42 | 17.22 | -4.6% |
| 06 | 15~19 | 16.98 | 17.11 | -0.8% |
| 07 | 15~19 | 16.35 | 17.09 | -4.3% |
| 08 | 15~19 | 16.75 | 17.25 | -2.9% |
| 09 | 15~19 | 16.77 | 17.45 | -3.9% |
| 10 | 15~19 | 16.92 | 17.42 | -2.9% |
| 11 | 15~19 | 16.41 | 17.29 | -5.1% |
| 12 | 15~19 | 16.89 | 17.30 | -2.4% |
| 13 | 15~19 | 16.98 | 17.36 | -2.2% |
| 14 | 15~19 | 17.42 | 17.50 | -0.5% |
| 15 | 15~19 | 16.80 | 17.39 | -3.4% |
| 16 | 15~19 | 16.43 | 17.18 | -4.4% |
| 17 | 15~19 | 16.70 | 17.81 | -6.2% |
| 18 | 15~19 | 17.02 | 17.87 | -4.8% |
| 19 | 15~19 | 17.20 | 17.96 | -4.2% |
| 20 | 15~19 | 17.17 | 17.77 | -3.4% |

The first column "Parameter Items" in Table 1 lists the parameter item codes; the second column "Preset range of standard power output value" lists the preset range of standard power output value corresponding to each parameter item, in arbitrary units; the third column "Calculated power output value" lists the power output value corresponding to the calibration parameter value of each parameter item of the power amplifier calculated by the AI background process program of the present invention, in arbitrary units; the fourth column "Actual measured power output value" lists the power output value actually measured by a one-box-tester after the calibration parameter values of each parameter item calculated above are loaded into the power amplifier, in arbitrary units; the fifth column "Error" lists the error value of the calculated power output value relative to the actual measured power output value.

As shown, for the 20 parameter items of the power amplifier, both the "calculated power output value" and the "actual measured power output value" fall within the "preset range of standard power output value", and the maximum error value does not exceed 8%. In other words, the calibration parameter values and corresponding power output values of the parameter items calculated (predicted) by the AI background process program of the present invention are highly accurate, cause small errors, and are reliable. The actual power output value of the power amplifier loaded with the calculated calibration parameter values is also within the preset range of standard power output value corresponding to each parameter item. In other words, the quality of the power amplifier that uses the artificial intelligence background process program of the present invention to assist parameter calibration meets the preset specifications after calibration.

According to an embodiment of the present invention, the calibration method for parameters of a power amplifier may further include step 4: inputting the calibration parameter values and corresponding power output values of the N parameters of the calibrated power amplifier into the AI server to establish a second parameter prediction model, and loading the second parameter prediction model into the AI background process program to update the parameter prediction model of the artificial intelligence background process program. Such repeated operation can improve the prediction accuracy of the parameter prediction model.

The following is an embodiment of a complete calibration process of the calibration method for parameters of a power amplifier according to the present invention.

First, the operator obtains the calibration parameter values of 8 parameters (for example, parameter numbers 01 to 08) of the power amplifier to be calibrated and the corresponding power output values through a test computer by trial-and-error approach, wherein the power amplifier has been installed in a radio frequency communication component, the radio frequency communication component is connected to a one-box-tester, and the one-box-tester is connected to the test computer. The power amplifier of the present embodiment has 60 parameters that need to be calibrated, but the present invention is not limited thereto.

Next, the operator inputs the calibration parameter values of the 8 parameters (parameter numbers 01 to 08) obtained by manual testing into the edge AI computing box via the test computer, so as to obtain the calibration parameter values of the remaining 52 parameters (for example, parameter numbers 09 to 60) of the power amplifier to be calibrated and the corresponding power output values through the calculation of the AI computing box, wherein a parameter prediction model has been established in the edge AI computing box, and the edge AI computing box is connected to the test computer.

Then, the operator loads the calibration parameter values of 60 parameters (parameter numbers 01 to 60) (including 8 calibration parameter values obtained by manual testing and 52 calibration parameter values calculated by the edge AI computing box) into the power amplifier via the test computer, completing the parameter calibration of the power amplifier in the RF communication component.

Next, the operator verifies the RF power output value of the calibrated RF communication component through a test computer, generates a power output value table, and stores the table in the test computer, wherein the power output value table at least includes data such as calibration parameter values and corresponding power output values.

Finally, the power output value table is uploaded to and stored in the AI server via the test computer. Based on the data in the power output value table and the preset conditions, a new parameter prediction model is established regularly or irregularly to update the parameter prediction model in the AI computing box operation, thereby improving and enhancing the calculation (prediction) accuracy of the AI computing box operation, wherein the AI server is connected to the edge AI computing box, or is connected to the edge AI computing box via the test computer.

Although the present invention has been described with reference to the preferred embodiments thereof, it is apparent to those skilled in the art that a variety of modifications and changes may be made without departing from the scope of the present invention which is intended to be defined by the appended claims.

## Claims

1. A calibration method for parameters of a power amplifier, the power amplifier having N parameters, each of the N parameters having a preset range of standard power output value, the method comprising:
step 1, manually calibrating parameter values of N1 parameters among the N parameters to obtain calibration parameter values of the N1 parameters;
step 2, inputting the calibration parameter values of the N1 parameters into an artificial intelligence (AI) background process program to calculate the calibration parameter values of the remaining N2 parameters by the artificial intelligence background process program, wherein N2 = N - N1; and
step 3, loading the calibration parameter values of the N parameters into the power amplifier to complete the calibration of the power amplifier parameters.

2. The method according to claim 1, wherein step 1 further comprises:
step 1-1, manually inputting a parameter value of a first parameter among the N1 parameters into the power amplifier;
step 1-2, reading the power output value of the power amplifier;
step 1-3, confirming whether the power output value of the power amplifier is within a preset range of standard power output value corresponding to the first parameter, if so, the input parameter value is a calibration parameter value of the first parameter, and continue to calibrate another parameter, if not, repeating steps 1-1 to 1-3; and
step 1-4, obtaining the calibration parameter values of the N1 parameters by repeating steps 1-1 to 1-3.

3. The method according to claim 1, wherein step 2 further comprises:
step 2-1, providing a first power amplifier, the first power amplifier having the N parameters, the first power amplifier having been manually calibrated, inputting the calibration parameter values of the N parameters of the first power amplifier and the corresponding power output value into an artificial intelligence server to establish a first parameter prediction model, and loading the first parameter prediction model into the artificial intelligence background process program; and
step 2-2, inputting the calibration parameter values of the N1 parameters of the power amplifier into the first parameter prediction model of the artificial intelligence background process program, so as to calculate the calibration parameter values of the remaining N2 parameters of the power amplifier by means of the first parameter prediction model.

4. The method according to claim 3, further comprising:
step 4, inputting the calibration parameter values of the N parameters of the power amplifier and the corresponding power output values into the artificial intelligence server to establish a second parameter prediction model, and loading the second parameter prediction model into the artificial intelligence background process program to update the parameter prediction model of the artificial intelligence background process program.

5. The method according to claim 3, wherein the artificial intelligence background process program is loaded into an artificial intelligence edge computing box, and the artificial intelligence edge computing box is connected to a test computer.

6. The method according to claim 3, wherein the method of establishing a parameter prediction model using the artificial intelligence server includes: a linear regression algorithm, a random forest regression algorithm, a gradient boosting regression algorithm, a support vector regression algorithm, a neural network algorithm, or a combination thereof.

7. The method according to claim 2, wherein step 1-1 further comprises:
using a one-box-tester connected to a test computer; connecting a radio frequency communication component with the power amplifier to the one-box-tester; and manually inputting the parameter value of the first parameter among the N1 parameters into the power amplifier via the test computer and the one-box-tester to control the radio frequency communication component to transmit a radio frequency signal.

8. The method according to claim 7, wherein step 1-2 further comprises:
using the one-box-tester to receive an RF signal and read an power value of the RF signal, wherein the power value is the power output value of the power amplifier corresponding to the parameter value of the first parameter.

9. The method according to claim 8, wherein step 1-3 include:
using the one-box-tester to transmit the power value of the RF signal back to the test computer; and using the test computer to determine whether the power value of the RF signal is within a preset range of standard power output value corresponding to the first parameter.

10. A radio frequency (RF) communication component, comprising:
a power amplifier calibrated by the method according to claim 1.
